# EUROPEAN PATENT SPECIFICATION

(11) **EP 3 800 452 B1**
(45) Date of publication and mention of the grant of the patent: **15.12.2021**
(21) Application number: 19306282.5
(22) Date of filing: 04.10.2019
(51) Int. Cl.: G01K 1/14, G01K 1/16, H05K 1/18, H05K 3/40, B60S 1/08, H05K 1/02

(54) **TEMPERATURE SENSOR DEVICE FOR A WINDSHIELD OF A VEHICLE**
TEMPERATURSENSORVORRICHTUNG FÜR EINE WINDSCHUTZSCHEIBE EINES FAHRZEUGS
DISPOSITIF CAPTEUR DE TEMPÉRATURE POUR PARE-BRISE DE VÉHICULE

(43) Date of publication of application: 07.04.2021
(73) Proprietor: MEAS France, 31027 Toulouse Cedex 3 (FR)
(72) Inventor: Vidal, Yannick, 31270 Cugnaux (FR); Leger, Vincent, 31200 Toulouse (FR)
(74) Representative: Grünecker Patent- und Rechtsanwälte PartG mbB

(56) References cited:
- FR-A1- 2 943 416
- JP-B2- 6 191 507
- US-A1- 2006 087 820
- US-B2- 7 405 669

## Description

### Field of Invention

The present invention relates to a temperature sensor device for sensing the temperature of a windshield of a vehicle, in particular, a windshield of an automobile.

### Background of the invention

Temperature sensors, humidity sensors, optical sensors or a combination thereof are known to be used in windshield sensing devices installed in vehicles for the purpose of automatically controlling the heating, ventilation, air conditioning and operation of the windshield wiper. As an example, a windshield temperature sensing device is commonly used for preventing fogging conditions.

For allowing a precise and reliable monitoring of the temperature and/or the humidity at a windshield of a vehicle, the sensor of the sensing device has to be reliably kept in constant contact with the surface of the windshield during the whole lifetime of the vehicle, and thus the sensor and connection of the same to the windshield has to withstand mechanical shocks and vibrations over the entire lifetime. Therefore, the sensor needs to be securely attached to the windshield.

US 7 405 669 B2 discloses a sensor element in thermal contact with a windshield of a vehicle and fastened to a support plate. Thermal coupling to the windshield is facilitated by a metal spring, a heat conducting film and connecting lines that are formed together with other strip conductors and electronic components on the support plate. JP 6 191507 B2 and US 2006/087820 A1 disclose temperature sensor elements formed on PCBs. FR 2 943 416 A1 discloses a temperature sensor element formed on an edge portion of a PCB.

In the art, sensor devices comprising printed circuit boards (PCBs) are known. For example, a thermistor is attached to a flexible polyimide film. One end of the polyimide film is connected to a PCB and another end, on which the thermistor is attached, is attached to the windshield surface 20. The end provided with the thermistor can be pressed against the windshield surface by means of foam elements made of thermal foam, arranged on either side of the thermistor. However, the foam used for fixing the polyimide film with the thermistor on the windshield is subject to ageing, degradation and/or mechanical stress. Furthermore, the soldering of the thermistor on the polyimide film, the soldering of the sensing device to the PCB and the soldering of the connector pin contact to the PCB represents a rather complex and costly manufacturing procedure.

According to another approach the windshield temperature is measured by means of a thermistor attached to one PCB in contact with the windshield and connected to another PCB providing the processing of the measurement data via two spring elements that are also used to try to keep permanent contact of the PCB that is provided with the thermistor with the windshield surface. Again, the overall manufacturing procedure is rather time-consuming and expensive and the resulting structure is rather complex and prone to detachment from the windshield.

According to an alternative approach a thermistor is placed on a flexible PCB. Again, the overall manufacturing procedure is rather time-consuming and expensive.

In view of the above, it is an object of the present invention to provide a temperature sensor device for a windshield of a vehicle that can be easily manufactured at low costs and still allows for a reliable and permanent sensing operation.

### Description of the Invention

The present invention addresses the above-mentioned object by providing a temperature sensor device for sensing the temperature of a windshield of a vehicle, comprising a single printed circuit board (PCB) comprising a circuitry and a tab portion extending from the single printed circuit board and configured to contact the windshield such that a main surface of the single printed circuit board is arranged substantially perpendicular to the windshield when the temperature sensor device is sensing the temperature of the windshield, a temperature sensor (temperature sensing device) mounted to the tab portion of the printed circuit board, and a thermally conductive pad attached to the temperature sensor and the tab portion, in particular, an edge of the tab portion, and arranged to thermally and mechanically directly contact the (inner surface of the) windshield.

The circuitry may comprise a measurement and control circuitry for processing data sensed by the temperature sensor and for controlling the temperature sensor. The temperature sensor may be a thermistor. The conductive pad may consist of or comprise a metal material, for example, a noble metal, as for instance, gold or copper. The temperature sensor can, for example, be soldered to the printed circuit board. The printed circuit board can be a non-flexible (rigid) printed circuit board. Another sensor, for example, a humidity sensor may be additionally mounted on the printed circuit board.

The thus defined configuration can be relatively easily and cost-efficiently produced using one single PCB only on which the temperature sensor is mounted. Particularly, by means of the thermally conductive pad attached to the temperature sensor and arranged to directly contact the (inner surface of the) windshield an easily to realize thermal contact allowing for a long-term reliable temperature measurement procedure is achieved.

By provision of the tab portion, positioning of the temperature sensor such that it contacts the windshield via the conductive pad can be facilitated. The thermally conductive pad is attached to the tab portion of the printed circuit board in order to facilitate a reliable and permanent thermal contact to the windshield. In particular, the thermally conductive pad may be attached to an edge of the tab portion of the printed circuit board.

The printed circuit board comprises electrically and thermally conductive lines, in particular, copper lines, that may be arranged to receive some heat flow from the windshield and the temperature sensor may be arranged in thermal contact with at least some of the conductive lines. When the temperature sensor device is attached to a windshield of a vehicle the conductive lines may provide a thermal conduction of heat radiated by windshield the towards the temperature sensor whereby the accuracy of the temperature measurement can be significantly increased.

Furthermore, the printed circuit board may comprise openings arranged between at least portions of the circuitry and the temperature sensor. Such openings also increase the accuracy of the temperature measurement since the influence of heat generated by the electronic components of the circuitry on the temperature sensing carried out by the temperature sensor can significantly be reduced.

The temperature sensor device according to one of the above-described embodiments may further comprise attachment means configured to attach the temperature sensor device to the windshield wherein the attachment means comprises at least one portion arranged and configured to conduct heat emitted by the circuitry away from the temperature sensor in order to further increase the accuracy of the temperature measurement by the temperature sensor device.

The attachment means may comprise or consist of a clip member, in particular, a clip member made of or comprising a metal material, wherein the at least one portion arranged and configured to conduct heat emitted by the circuitry away from the temperature sensor is part of the clip member.

Furthermore, it is provided a defogging control means or a wiper operation control means for a motor vehicle comprising a windshield, the defogging control means or the wiper operation control means comprising a humidity sensor device for sensing the humidity of the windshield and the temperature sensor device according to one of the above-described embodiments.

Additional features and advantages of the present invention will be described with reference to the drawings. In the description, reference is made to the accompanying figures that are meant to illustrate preferred embodiments of the invention. It is understood that such embodiments do not represent the full scope of the invention.
Figure 1 illustrates an exemplary embodiment of a temperature sensor device according to the present invention and a cross-sectional view of a part of the temperature sensor device.
Figure 2 illustrates aspects related to heat control in the context of an exemplary embodiment of a temperature sensor device according to the present invention

The present invention provides a temperature sensor device for sensing the temperature of a windshield of a vehicle wherein the temperature sensor device comprises a single non-flexible PCB and a temperature sensor mounted on the PCB. A non-flexible PCB, i.e., rigid PCB, cannot be bended or rolled up significantly without breakage. The bend radius of the PCB used herein may, in particular, be below 1 mm. The temperature sensor device comprises a temperature sensor that is in thermal contact with the windshield via a thermally conductive pad.

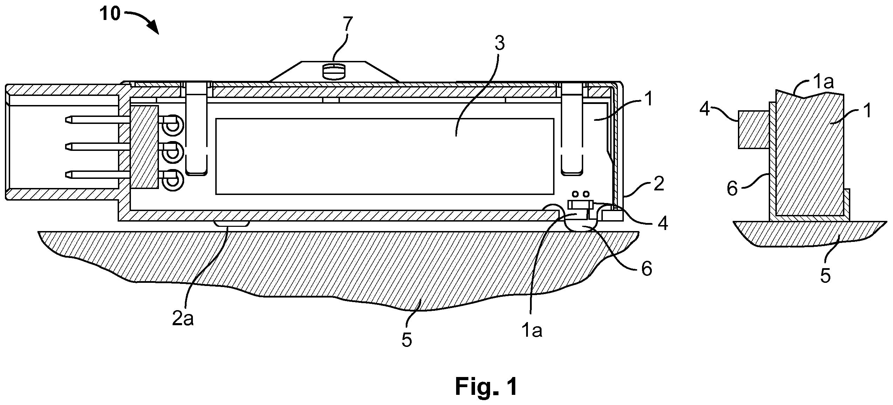

Figure 1 exemplarily shows an embodiment of a temperature sensor device 10 according to the invention as well as a cross-sectional view of the temperature sensor device 10 in the direction of the arrow shown. A PCB 1 is encased in a housing 2. Some circuitry 3 is formed on the PCB 1. The circuitry 3 comprises circuitry elements used for data processing and sensor control.

The PCB comprises a tab portion 1a. A temperature sensor 4 is attached to the tab portion 1a of the PCB. Thereby, the temperature sensor 4 is directly mounted to the PCB 1. For example, the temperature sensor 4 is soldered to the tab portion 1a. In fact, the temperature sensor 4 can be soldered to the tab portion 1a of the PCB 1 within the process of soldering all or some of the other electronic components of the circuitry 3 (during some reflow processing, for example) to the PCB 1.

According to an embodiment the temperature sensor 4 is a thermistor. The thermistor can be a Negative Temperature Coefficient (NTC) thermistor that is characterized by a resistance decreasing exponentially with the sensed temperature. The NTC thermistor may be made based on polycrystalline oxide ceramics, in particular, exhibiting a crystal structure that is basically a Spinel structure resulting from a sintering process.

In order to sense the temperature of a windshield 5 of a vehicle a reliable thermal contact to the windshield 5 has to be provided. As shown in Figure 1 the thermal contact is provided by means of a thermally conductive pad 6 connected to the temperature sensor 4. The thermally conductive pad 6 may be made of or comprise a noble metal, for example, gold or copper or some alloy thereof. It is noted that the temperature sensor 4 has not to directly contact the windshield but the contact is made via the thermally conductive pad 6. Thereby, a degradation of the temperature sensor 4 during the lifetime can be reduced. The housing 2 comprises an extension 2a corresponding to the thermally conductive pad 6 that may also contact the windshield 5.

In order to attach the temperature sensor device 10 to the windshield 5 an attachment means 7 is provided. The attachment means 7 of the temperature sensor device 10 can comprises a clip member, for example, a metallic clip member, that is configured to be clipped to a bracket member that may be positioned at the windshield or a rear-view mirror installed in a vehicle, for example.

When the clip member 7 is fastened to the bracket member a reliable and permanent mechanical and thermal contact between the windshield 5 and the temperature sensor device 10 (and - via the thermally conductive pad 6 - the temperature sensor 4 of the temperature sensor device 10) is achieved. By means of the temperature sensor device 10 a low cost defogging control and/or wiper control in an automobile compartment can be realized, for example.

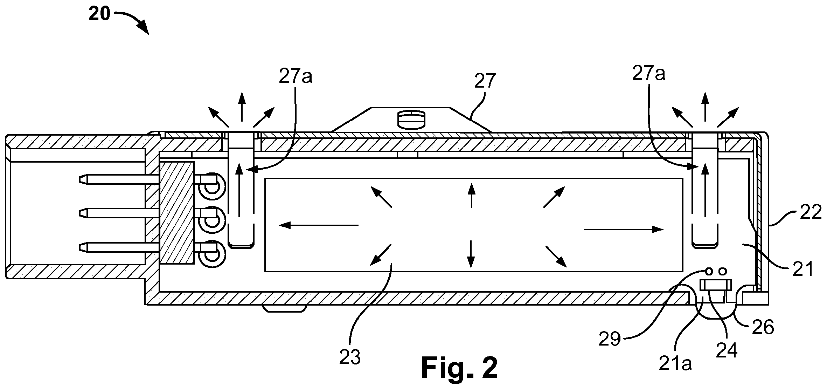

Another embodiment of an inventive temperature sensor device 20 is illustrated in Figure 2. The temperature sensor device 20 is very similar to the one shown in Figure 1. The temperature sensor device 20 comprises a single rigid PCB 21 that is encased in a housing 22. Some circuitry 23 is formed on the PCB 21. The circuitry 23 comprises circuitry elements used for data processing and sensor control.

A temperature sensor 24, for example, a (NTC) thermistor, is attached to a tab portion 21a of the PCB 21. Thereby, the temperature sensor 24 is directly mounted to the PCB 1. For example, the temperature sensor 24 is soldered to the tab portion 21a of the PCB 21. The temperature sensor 24 is connected to a thermally conductive pad 26 that may be made of or comprise a noble metal, for example, gold. The thermally conductive pad 26 provides a thermal contact with the windshield the temperature of which has to be sensed by the temperature sensor 24.

A clip member 27 serves for attachment of the temperature sensor device 20 to a windshield of a vehicle. The clip member comprises clip tabs 27a that are fastened to the housing and may also be fastened to the PCB 21. Particularly, the clip tabs 27a are in thermal contact with the circuitry 23 that is formed on the PCB 21

Heat flow of heat generated by the electronic components of the PCB 21 is indicated by the arrows in Figure 2. It is desirable that heat generated by the electronic components of the circuitry 23 of the PCB 21 does not influence the measurement of the temperature of the windshield by means of the temperature sensor 24. Therefore, the clip tabs 27a of the clip member 27 are made of a material, for example, a metal material, that allows for conducting the heat away from the temperature sensor 24.

Additionally, some heat barrier may be provided for blocking heat flow towards the temperature sensor 24. In the embodiment shown in Figure 2 such a barrier comprises openings 29 formed in the PCB 21 that allow for the dissipation of heat generated by the electronic components of the circuitry 23 of the PCB 21.

### Reference Numbers

- 1, 21:: PCB
- 1a, 21a:: tab portion
- 2, 22:: housing
- 2a:: extension
- 3, 23:: circuitry
- 4, 24:: temperature sensor
- 5:: windshield
- 6, 26:: conductive pad
- 7:: attachment means
- 10, 20:: temperature sensor device
- 27:: clip member
- 27a:: clip tabs
- 29:: openings

## Claims

1. Temperature sensor device (10, 20) for sensing the temperature of a windshield (5) of a vehicle, comprising
a single printed circuit board (1, 21) comprising a circuitry (3, 23), in particular, a measurement and control circuitry (3, 23) and a tab portion (1a, 21a) extending from the single printed circuit board (1, 21) and configured to contact the windshield (5) such that a main surface of the single printed circuit board (1, 21) is arranged substantially perpendicular to the windshield (5) when the temperature sensor device (10, 20) is sensing the temperature of the windshield (5);
a temperature sensor (4, 24), in particular, a thermistor, mounted to the tab portion (1a, 21a) of the printed circuit board (1, 21); and
a thermally conductive pad (6, 26) attached to the temperature sensor (4, 24) and the tab portion (1a, 21a), in particular, an edge of the tab portion (1a, 21a), and arranged to thermally and mechanically directly contact the windshield (5).

2. The temperature sensor device (10, 20) according to claim 1, wherein the printed circuit board (1, 21) comprises electrically and thermally conductive lines, in particular, copper lines, arranged to receive some heat flow from the windshield (5) and wherein the temperature sensor (4, 24) is arranged in thermal contact with at least some of the electrically and thermally conductive lines.

3. The temperature sensor device (10, 20) according to one of the preceding claims, wherein the printed circuit board (1, 21) comprises openings (29) arranged between at least portions of the circuitry (3, 23) and the temperature sensor (4, 24).

4. The temperature sensor device (10, 20) according to one of the preceding claims, wherein the temperature sensor (4, 24) is soldered to the printed circuit board (1, 21).

5. The temperature sensor device (10, 20) according to one of the preceding claims, wherein the printed circuit board (1, 21) is a non-flexible printed circuit board (1, 21).

6. The temperature sensor device (10, 20) according to one of the preceding claims, further comprising an attachment means (7) configured to attach the temperature sensor device (10 20) to the windshield (5) and wherein the attachment means (7) comprises at least one portion (27a) arranged and configured to conduct heat emitted by the circuitry (3, 23) away from the temperature sensor (4, 24).

7. The temperature sensor device (10, 20) according to claim 6, wherein the attachment means (7) comprises or consists of a clip member (27), in particular, a clip member (27) made of or comprising a metal material, and wherein the at least one portion (27a) arranged and configured to conduct heat emitted by the circuitry (3, 23) away from the temperature sensor (4, 24) is part of the clip member (27).

8. A defogging control means or a wiper operation control means for a motor vehicle comprising a windshield (5), the defogging control means or wiper operation control means comprising
a humidity sensor device configured for sensing the humidity of the windshield (5); and
the temperature sensor device (10, 20) according to one of the preceding claims.

## Patentansprüche

1. Temperatursensorvorrichtung (10, 20) zum Detektieren der Temperatur einer Windschutzscheibe (5) eines Fahrzeugs, die umfasst
eine einzelne Leiterplatine (1, 21) mit einer Schaltung (3, 23), insbesondere einer Messungs- und Steuerungsschaltung (3, 23), und einem Auslegerbereich (1a, 21a), der sich von der Leiterplatine (1, 21) erstreckt und dazu ausgebildet ist, die Windschutzscheibe (5) zu kontaktieren, sodass eine Hauptfläche der Leiterplatine (1, 21) im Wesentlichen senkrecht zu der Windschutzscheibe (5) angeordnet ist, wenn die Temperatursensorvorrichtung (10, 20) die Temperatur der Windschutzscheibe (5) detektiert;
einen Temperatursensor (4, 24), insbesondere einen Thermistor, der an dem Auslegerbereich (1a, 21a) der Leiterplatine (1, 21) angebracht ist; und
eine thermisch leitfähige Unterlage (6, 26), die an dem Temperatursensor (4, 24) und dem Auslegerbereich (1a, 21a), insbesondere an einer Kante des Auslegerbereichs (1a, 21a), befestigt ist und so angeordnet ist, dass sie die Windschutzscheibe (5) direkt thermisch und mechanisch kontaktiert.

2. Die Temperatursensorvorrichtung (10, 20) gemäß Anspruch 1, in der die Leiterplatine (1, 21) elektrisch und thermisch leitfähige Leitungen, insbesondere Kupferleitungen, umfasst, die so angeordnet sind, dass sie einen Wärmestrom von der Windschutzscheibe (5) empfangen, und wobei der Temperatursensor (4, 24) in thermischem Kontakt mit zumindest einigen der elektrisch und thermisch leitfähige Leitungen angeordnet ist.

3. Die Temperatursensorvorrichtung (10, 20) gemäß einem der vorhergehenden Ansprüche, in der die Leiterplatine (1, 21) Öffnungen (29) umfasst, die zwischen zumindest Teilen der Schaltung (3, 23) und dem Temperatursensor (4, 24) angeordnet sind.

4. Die Temperatursensorvorrichtung (10, 20) gemäß einem der vorhergehenden Ansprüche, in der der Temperatursensor (4, 24) an die Leiterplatine (1, 21) gelötet ist.

5. Die Temperatursensorvorrichtung (10, 20) gemäß einem der vorhergehenden Ansprüche, in der die Leiterplatine (1, 21) eine nicht flexible Leiterplatine (1, 21) ist.

6. Die Temperatursensorvorrichtung (10, 20) gemäß einem der vorhergehenden Ansprüche, die weiterhin ein Befestigungsmittel (7) umfasst, das dazu ausgebildet ist, die Temperatursensorvorrichtung (10, 20) an der Windschutzscheibe (5) zu befestigen, und wobei das Befestigungsmittel (7) zumindest einen Teil (27a) umfasst, der angeordnet und dazu ausgebildet ist, Wärme, die von der Schaltung (3, 23) abgestrahlt wird, von dem Temperatursensor (4, 24) weg zu leiten.

7. Die Temperatursensorvorrichtung (10, 20) gemäß Anspruch 6, in der das Befestigungsmittel (7) aus einem Klemmelement (27), insbesondere aus einem Klemmelement (27), das aus einem Metallmaterial besteht oder dieses umfasst, besteht oder dieses umfasst, und wobei der zumindest eine Teil (27a), der angeordnet und dazu ausgebildet ist, Wärme, die von der Schaltung (3, 23) abgestrahlt wird, von dem Temperatursensor (4, 24) weg zu leiten, Teil des Klemmelements (27) ist.

8. Ein Anti-Beschlag-Steuerungsmittel oder ein Scheibenwischerbetätigung-Steuerungsmittel für ein Motorfahrzeug mit einer Windschutzscheibe (5), wobei das Anti-Beschlag-Steuerungsmittel oder Scheibenwischerbetätigung-Steuerungsmittel umfasst
eine Feuchtigkeitssensorvorrichtung, die dazu ausgebildet ist, die Feuchtigkeit der Windschutzscheibe (5) zu detektieren; und
die Temperatursensorvorrichtung (10, 20) gemäß einem der vorhergehenden Ansprüche.

## Revendications

1. Dispositif capteur de température (10, 20) pour détecter la température d'un pare-brise (5) d'un véhicule, comprenant
une carte à circuit imprimé unique (1, 21) comprenant un circuit (3, 23), en particulier, un circuit de mesure et de commande (3, 23) et une partie de languette (1a, 21a) s'étendant à partir de la carte à circuit imprimé unique (1, 21) et configurée pour entrer en contact avec le pare-brise (5) de telle sorte qu'une surface principale de la carte à circuit imprimé unique (1, 21) est disposée sensiblement perpendiculairement au pare-brise (5) lorsque le dispositif capteur de température (10, 20) détecte la température du pare-brise (5) ;
un capteur de température (4, 24), en particulier, une thermistance, monté sur la partie de languette (1a, 21a) de la carte à circuit imprimé (1, 21) ; et
un plot thermiquement conducteur (6, 26) fixé au capteur de température (4, 24) et à la partie de languette (1a, 21a), en particulier, un bord de la partie de languette (1a, 21a), et agencé pour entrer directement en contact thermiquement et mécaniquement avec le pare-brise (5).

2. Dispositif capteur de température (10, 20) selon la revendication 1, dans lequel la carte à circuit imprimé (1, 21) comprend des lignes électriquement et thermiquement conductrices, en particulier, des lignes en cuivre, agencées pour recevoir un certain flux de chaleur en provenance du pare-brise (5) et dans lequel le capteur de température (4, 24) est agencé en contact thermique avec au moins certaines des lignes électriquement et thermiquement conductrices.

3. Dispositif capteur de température (10, 20) selon l'une des revendications précédentes, dans lequel
la carte à circuit imprimé (1, 21) comprend des ouvertures (29) agencées entre au moins des parties du circuit (3, 23) et le capteur de température (4, 24).

4. Dispositif capteur de température (10, 20) selon l'une des revendications précédentes, dans lequel le capteur de température (4, 24) est soudé à la carte à circuit imprimé (1, 21).

5. Dispositif capteur de température (10, 20) selon l'une des revendications précédentes, dans lequel la carte à circuit imprimé (1, 21) est une carte à circuit imprimé non-flexible (1, 21).

6. Dispositif capteur de température (10, 20) selon l'une des revendications précédentes, comprenant en outre des moyens de fixation (7) configurés pour fixer le dispositif capteur de température (10, 20) au pare-brise (5) et dans lequel les moyens de fixation (7) comprennent au moins une partie (27a) agencée et configurée pour conduire de la chaleur émise par le circuit (3, 23) à l'opposé du capteur de température (4, 24).

7. Dispositif capteur de température (10, 20) selon la revendication 6, dans lequel les moyens de fixation (7) comprennent ou consistent en un élément d'attache (27), en particulier, un élément d'attache (27) constitué ou comprenant un matériau métallique, et dans lequel la au moins une partie (27a) agencée et configurée pour conduire de la chaleur émise par le circuit (3, 23) à l'opposé du capteur de température (4, 24) fait partie de l'élément d'attache (27).

8. Moyens de commande de désembuage ou moyens de commande de fonctionnement d'essuie-glace pour un véhicule motorisé comprenant un pare-brise (5), les moyens de commande de désembuage ou les moyens de commande de fonctionnement d'essuie-glace comprenant
un dispositif capteur d'humidité configuré pour détecter l'humidité du pare-brise (5) ; et
le dispositif capteur de température (10, 20) selon l'une des revendications précédentes.
